# EUROPEAN PATENT APPLICATION

(11) **EP 4 641 935 A1**
(43) Date of publication of application: **29.10.2025**
(21) Application number: 23905465.3
(22) Date of filing: 31.10.2023
(51) Int. Cl.: H04B 1/401

(54) **FAST-SWITCHING RADIO FREQUENCY SWITCH CIRCUIT, CHIP AND ELECTRONIC DEVICE THEREOF**

(30) Priority: 20.12.2022 CN 202211644235
(71) Applicant: Shanghai Vanchip Technologies Co., Ltd., Shanghai 201203 (CN)
(72) Inventor: DI, Jinghao, Shanghai 201203 (CN); ZHANG, Huashuo, Shanghai 201203 (CN)
(74) Representative: Wang, Bo
(86) International application number: PCT/CN2023/128134
(87) International publication number: WO 2024/131293

(57) **Abstract**

Disclosed in the present invention are a fast-switching radio frequency switch circuit, a chip and an electronic device thereof. The radio frequency switch circuit comprises a series switch branch and a parallel switch branch of at least one transmission path, and a series switch branch and a parallel switch branch of at least one reception path. In said transmission path, two ends of the series switch branch are respectively connected to a transmission end and an antenna end, and two ends of the parallel switch branch are respectively connected to the transmission end and a grounding potential end. In said reception path, two ends of the series switch branch are respectively connected to a reception end and the antenna end, and two ends of the parallel switch branch are respectively connected to the reception end and the grounding potential end. By means of an optimized structural design, the radio frequency switch circuit achieves fast switching of operating modes of radio frequency front-end systems while ensuring performance indexes such as power handling capacity and linearity and not increasing the cost, thus improving the transmission rate of communication systems.

## Description

### BACKGROUND

### Technical Field

The present disclosure relates to a fast-switching radio frequency switch circuit, and also to an integrated circuit chip and corresponding electronic device including the radio frequency switch circuit, and belongs to the technical field of radio frequency integrated circuits.

### Related Art

In a wireless communication system, a radio frequency switch is one of key modules in a radio frequency front-end circuit. Its function is to accurately and synchronously switch transmission paths of radio frequency signals, gate corresponding radio frequency signal paths, and achieve the reception and transmission of radio frequency signals in the case of shared antennas in the system.

With the continuous development of a radio frequency integrated circuit technology and a trend of diversified application scenarios in a communication terminal, a radio frequency front-end system of a mobile communication terminal needs to support an increasing number of operating modes and frequency bands, and the radio frequency front-end system has increasingly higher requirements on radio frequency switch performance indexes. The main performance indicators of the radio frequency switch include power handling capacity, isolation, linearity, and insertion loss. Additionally, a switching time of the radio frequency switch is also a very important performance index, which directly affects a transmission rate of the communication system.

In the prior art, there are usually three structural schemes for radio frequency switch circuits, including series-parallel radio frequency switch, relative negative voltage radio frequency switch, and constant negative voltage radio frequency switch.

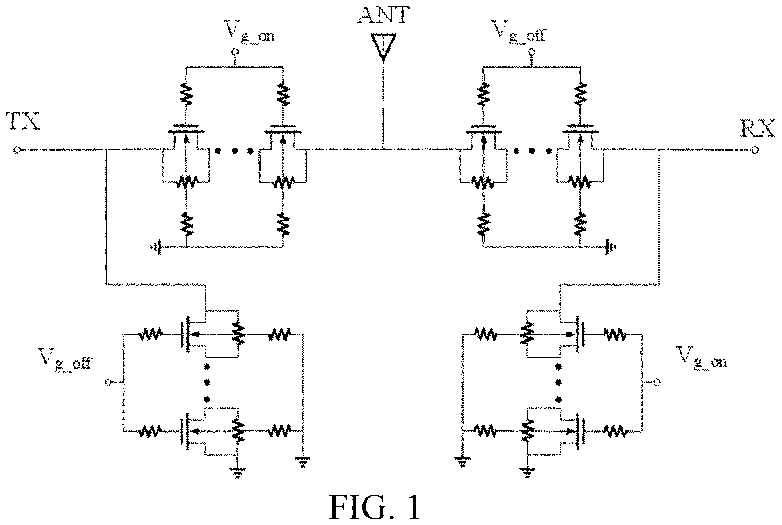

A series-parallel radio frequency switch circuit is as shown in FIG. 1, where each series-parallel switch branch is composed of stacked switching transistors. Gate voltage of the switching transistor in each turn-on branch is 2.5 V, and gate voltage of the switching transistor in each turn-off branch is 0 V. Aradio frequency switch circuit structure in this scheme is simple, a chip area is small, and a switching time of transmission and reception links is small. However, a disadvantage of this scheme is that the linearity of the radio frequency switch is poor as a number of the stacked switching transistors increases.

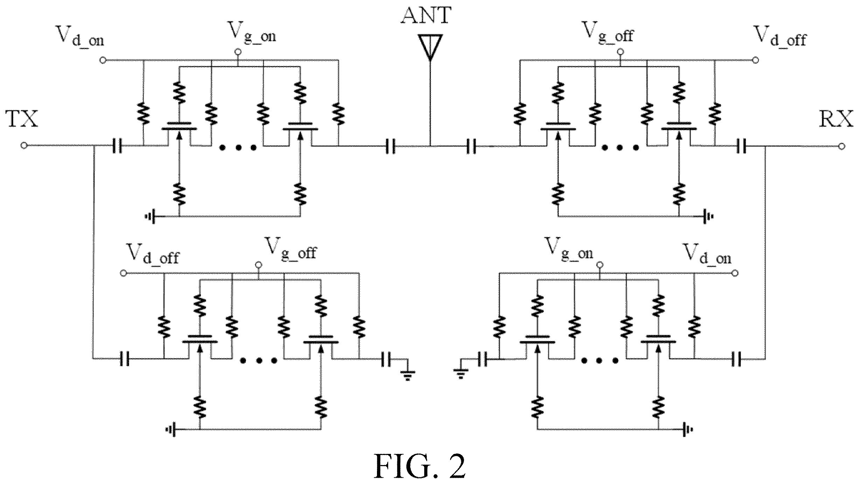

A relative negative voltage radio frequency switch circuit is as shown in FIG. 2, where each series-parallel switch branch is composed of stacked switching transistors connected with capacitors in series. A gate of the switching transistor in each turn-on branch is biased to high potential, a source is biased to low potential, and the switch will be turned on when its gate-source voltage is greater than a threshold voltage; a gate of the switching transistor in each turn-off branch is biased to low potential, a source is biased to high potential, and the switch is turned off when its gate-source voltage is negative. A radio frequency switch circuit structure in this scheme is relatively simple and has good linearity. However, a disadvantage of this scheme is that the chip area is large and the switching time of transmission and reception links is long.

In a constant negative voltage radio frequency switch circuit, a gate and body of the switching transistor in each turn-off branch are biased to constant negative voltage, which is generated by a charge pump driven by a fully differential ring oscillator. A linearity of the constant negative voltage radio frequency switch circuit is significantly improved, while the switching time of transmission and reception links is relatively short. However, a disadvantage of this scheme is that the structure is very complex, a power consumption is high, and a cost is significantly increased.

Therefore, how to reduce the switching time of the radio frequency switch and improve the transmission rate of the communication system while ensuring the performance indexes such as power handling capacity, isolation and linearity and not increasing the cost has always been a very important technical research topic in this field.

### SUMMARY

A primary technical problem to be solved by the present disclosure is to provide a fast-switching radio frequency switch circuit.

Another technical problem to be solved by the present disclosure is to provide an integrated circuit chip and corresponding electronic device including the radio frequency switch circuit.

In order to achieve the above purposes, the present disclosure adopts the following technical solutions:
According to a first aspect, an embodiment of the present disclosure provides a fast-switching radio frequency switch circuit, including a series switch branch and a parallel switch branch of at least one transmission path, and a series switch branch and a parallel switch branch of at least one reception path, where
in the transmission path, two ends of the series switch branch are respectively connected to a transmission end and an antenna end, and two ends of the parallel switch branch are respectively connected to the transmission end and a grounding potential end; and
in the reception path, two ends of the series switch branch are respectively connected to a reception end and the antenna end, and two ends of the parallel switch branch are respectively connected to the reception end and the grounding potential end.

When the transmission path or the reception path is in an operating state, the series switch branch in the path is closed and the parallel switch branch is opened; and
when the transmission path or the reception path is in a non-operating state, the series switch branch in the path is opened and the parallel switch branch is closed.

Preferably, the series switch branch and the parallel switch branch adopt a switching transistor stack structure composed of multiple switching transistors with sources and drains connected in series; and
a body of each switching transistor is connected to the grounding potential end through a body bias resistor, the drain and the source are respectively connected to the grounding potential end through a drain bias resistor and a source bias resistor, and a gate is connected to a bias voltage through a gate bias resistor.

Preferably, when a radio frequency switch is in a transmission operating mode,
in the series switch branch of the transmission path and the parallel switch branch of the reception path in the operating state, and the parallel switch branch of the transmission path in the non-operating state, a gate bias voltage of each switching transistor is a positive voltage; and
in the parallel switch branch of the transmission path and the series switch branch of the reception path in the operating state, and the series switch branch of the transmission path in the non-operating state, the gate bias voltage of each switching transistor is a grounding potential.

Preferably, when a radio frequency switch is in a reception operating mode,
in the series switch branch of the reception path and the parallel switch branch of the transmission path in the operating state, and the parallel switch branch of the reception path in the non-operating state, a gate bias voltage of each switching transistor is a positive voltage;
   and
in the parallel switch branch of the reception path and the series switch branch of the transmission path in the operating state, and the series switch branch of the reception path in the non-operating state, the gate bias voltage of each switching transistor is a grounding potential.

Preferably, a first parallel capacitor is additionally arranged at an end of the series switch branch of the reception path connected to the reception end, and two ends of the parallel capacitor are respectively connected to the gate and the source of each switching transistor to improve a linearity of a radio frequency switch.

Preferably, a first parallel capacitor and a second parallel capacitor are respectively additionally arranged at two ends of the series switch branch of the reception path, two ends of the first parallel capacitor are respectively connected to the gate and the source of each switching transistor on a reception end, and two ends of the second parallel capacitor are respectively connected to the gate and the drain of each switching transistor on an antenna end to improve a linearity of a radio frequency switch.

Preferably, a third parallel capacitor is additionally arranged at an end of the parallel switch branch of the transmission path connected to the grounding potential end, and two ends of the parallel capacitor are respectively connected to the gate and the source of each switching transistor to improve a linearity of a radio frequency switch.

Preferably, a third parallel capacitor and a fourth parallel capacitor are respectively additionally arranged at two ends of the parallel switch branch of the transmission path, two ends of the third parallel capacitor are respectively connected to the gate and the source of each switching transistor on a grounding potential end, and two ends of the fourth parallel capacitor are respectively connected to the gate and the drain of each switching transistor on a transmission end to improve a linearity of a radio frequency switch.

According to a second aspect, an embodiment of the present disclosure provides an integrated circuit chip, and the integrated circuit chip includes the radio frequency switch circuit described above.

According to a third aspect, an embodiment of the present disclosure provides an electronic device, and the electronic device includes the radio frequency switch circuit described above.

Compared with the prior art, in the fast-switching radio frequency switch circuit, the chip and the electronic device thereof provided in the present disclosure, by way of an optimized design of the radio frequency switch circuit, fast switching of operating modes of a radio frequency front-end system is achieved while ensuring performance indexes such as power handling capacity and linearity and not increasing a cost, thus improving a transmission rate of a communication system. Therefore, the fast-switching radio frequency switch circuit provided in the present disclosure has beneficial effects such as ingenious and reasonable design, simple structure, low cost and short switching time, and high linearity.

### BRIEF DESCRIPTION OF THE DRAWINGS

FIG. 1 is a schematic diagram of a series-parallel radio frequency switch circuit in the prior art.
FIG. 2 is a schematic diagram of a relative negative voltage radio frequency switch circuit in the prior art.
FIG. 3 is a schematic diagram of an architecture of a radio frequency front-end module in a Wi-Fi system in the prior art.
FIG. 4 is a schematic circuit diagram of a fast-switching radio frequency switch in a transmission operating mode according to an embodiment of the present disclosure.
FIG. 5 is a schematic circuit diagram of a fast-switching radio frequency switch in a reception operating mode according to an embodiment of the present disclosure.
FIG. 6 is a schematic circuit diagram of a technical solution for improving linearity of a radio frequency switch according to an embodiment of the present disclosure.
FIG. 7 is a schematic circuit diagram of another technical solution for improving linearity of a radio frequency switch according to an embodiment of the present disclosure.
FIG. 8 is a simulation test diagram of switching time of a relative negative voltage radio frequency switch circuit in the prior art.
FIG. 9 is a simulation test diagram of switching time of a fast-switching radio frequency switch circuit according to an embodiment of the present disclosure.
FIG. 10 is a schematic diagram of an electronic device adopting a radio frequency switch circuit provided by an embodiment of the present disclosure.

### DETAILED DESCRIPTION

The technical solutions of the present disclosure will be further described below in detail in combination with the specific embodiments with reference to the drawings.

For the convenience of understanding and description, the present disclosure firstly provides a brief introduction to the concept and connotation of a switching time of a radio frequency switch, and on this basis, the specific technical solutions of the embodiments of the present disclosure are described in detail.

In a radio frequency switch circuit, the specific definitions of the switching time are as follows: a time required from a control voltage at a 50% point to a radio frequency output signal amplitude reaching 90% in a branch for turn-on switching is turn-on switching time. A time required from a control voltage at a 50% point to a radio frequency output signal amplitude reaching 10% in a branch for turn-off switching is turn-off switching time.

The switching time, as one of the important performance indexes of the radio frequency switch, is fundamentally determined by the RC time constant representing a transition response in the switch circuit, which is positively correlated with an equivalent capacitance and an equivalent resistance of a switch branch. The equivalent capacitance of the switch branch mainly includes gate-source and gate-drain parasitic capacitance, and series DC-blocking capacitance and the like of the switch transistor in the branch. The equivalent resistance mainly includes gate resistance, source-drain equivalent resistance and the like of the switch transistor in the branch.

In a radio frequency front-end module of a mobile communication system, a main function of the radio frequency switch is to switch a transmission path of radio frequency signals. Depending on a composition structure of the communication system, the forms include single-pole-double throw (SPDT), single-pole multiple-throw (SP3T, SP4T, SP5T), and other forms. Description will be made below by taking an architecture of a radio frequency front-end module in a Wi-Fi system in the prior art as an example.

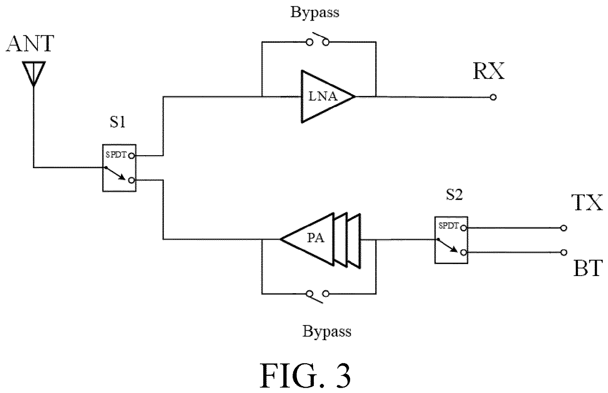

As shown in FIG. 3, the radio frequency front-end module includes at least one power amplifier (PA) transmission path and one bypass transmission path, and at least one low noise amplifier (LNA) reception path and one bypass reception path. A power amplifier (PA) and a Low noise amplifier (LNA) are supplied with power by separate low dropout linear regulators (LDOs).

In this front-end module architecture, a front-end system can achieve five operating modes through the on/off switching of a radio frequency switch S1 at an antenna end and a radio frequency switch S2 at a transmission end, including RX gain (amplification reception), RX bypass (bypass reception), TX gain (amplification transmission), BT gain (Bluetooth amplification transmission), BT bypass (Bluetooth bypass reception).

In order to improve a transmission rate of the Wi-Fi front-end system and reduce the switching time between various operating modes, in addition to the need to configure LDOs with strong load capacity to enable the power amplifier PA and low noise amplifier LNA power up quickly, an establishment time of a radio frequency signal path heavily depends on the switching time of the radio frequency switch in the signal path. Therefore, in order to overcome the problems existing in the radio frequency switch circuit in the prior art, on the premise of ensuring performance indexes such as power handling capacity and linearity and not increasing the cost, the present disclosure provides a fast-switching radio frequency switch circuit, which can reduce the switching time of the radio frequency switch circuit and improve the transmission rate of the communication system.

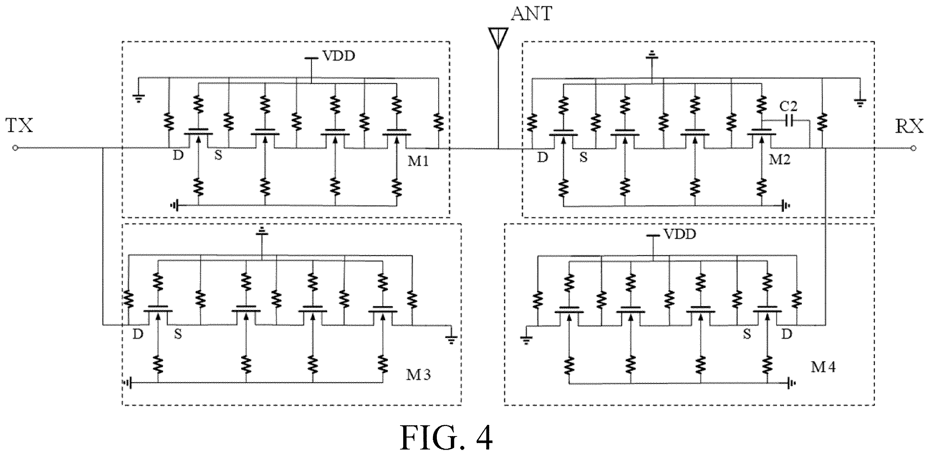

As shown in FIG. 4, in an embodiment of the present disclosure, a fast-switching radio frequency switch circuit includes a series switch branch M1 and a parallel switch branch M3 of at least one transmission path, and a series switch branch M2 and a parallel switch branch M4 of at least one reception path. After one end of the series switch branch M1 is connected to one end of the parallel switch branch M3 of the transmission path, they are jointly connected to a transmission end TX, an other end of the series switch branch M1 is connected to an antenna end (ANT), and an other end of the parallel switch branch M3 is connected to a grounding potential end. After one end of the series switch branch M2 is connected to one end of the parallel switch branch M4 in the reception path, they are jointly connected to a reception end RX, an other end of the series switch branch M2 is connected to the antenna end (ANT), and an other end of the parallel switch branch M4 is connected to the grounding potential end.

In an embodiment of the present disclosure, the series switch branches and the parallel switch branches in each transmission path and reception path adopt a switching transistor stack structure composed of multiple switching transistors with sources and drains sequentially connected in series. A number of series switching transistors is designed and selected according to the power of the radio frequency signal and ESD (electrostatic discharge protection) requirements. The switch branch shown in FIG. 4 is described by taking four switching transistors connected in series with each other as an example. In the stacked switching transistors, a body of each switching transistor is connected to the grounding potential end through a body bias resistor, the drain and the source are respectively connected to the grounding potential end through a drain bias resistor and a source bias resistor, and a gate is connected to a bias voltage Vg through a gate bias resistor.

When the radio frequency switch is in a transmission operating mode, as shown in FIG. 4, in the series switch branch M1 of the transmission path and the parallel switch branch M4 of the reception path, the gate bias voltage Vg of each switching transistor is a positive voltage VDD (usually 2.5-3.8 V); and in the parallel switch branch M3 of the transmission path and the series switch branch M2 of the reception path, the gate bias voltage Vg of each switching transistor is a grounding potential (usually 0 V). Therefore, the series switch branch M1 of the transmission path is turned on to close the transmission path, and the parallel switch branch M3 is turned off to make the transmission path operate normally, and at this time, the radio frequency signal is transmitted from the transmission end TX to the antenna end through the transmission path; and the series switch branch M2 of the reception path is turned off to open the reception path, and the parallel switch branch M4 is turned on and grounded to make the reception path and the transmission path isolated from each other.

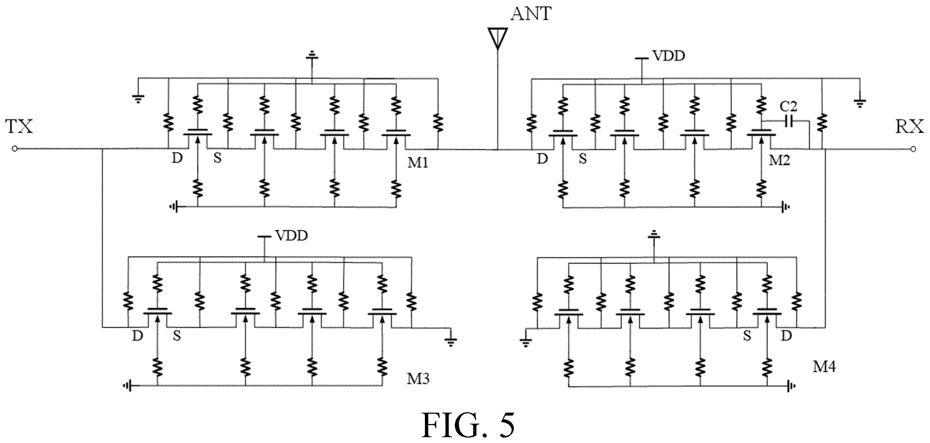

When the radio frequency switch is in a reception operating mode, as shown in FIG. 5, in the series switch branch M2 of the reception path and the parallel switch branch M3 of the transmission path, the gate bias voltage Vg of each switching transistor is a positive voltage VDD; and in the parallel switch branch M4 of the reception path and the series switch branch M1 of the transmission path, the gate bias voltage Vg of each switching transistor is a grounding potential. Therefore, the series switch branch M2 of the reception path is turned on to close the reception path, and the parallel switch branch M4 is turned off to make the reception path operate normally, and at this time, the radio frequency signal is transmitted from the antenna end to the reception end RX through the transmission path; and the series switch branch M1 of the transmission path is turned off to open the transmission path, and the parallel switch branch M3 is turned on and grounded to make the reception path and the transmission path isolated from each other.

Compared with the relative negative voltage radio frequency switch in the prior art, in a signal path switching process of the radio frequency switch circuit provided in this embodiment of the present disclosure, since the sources and the drains of the series switching transistors of the turn-on branch and the turn-off branch are at the grounding potential, large series DC-blocking capacitors in the branches are eliminated, thus reducing the switching time of the radio frequency switch circuit.

Moreover, in an embodiment of the present disclosure, in order to improve the linearity of the radio frequency switch, as shown in FIG. 4, a parallel small capacitor C2 is additionally arranged between the gate and the source of each switching transistor at the end of the series switch branch M2 of the reception path connected to the reception end RX. When the radio frequency switch is in the transmission operating mode and the radio frequency signal is transmitted from the transmission end TX to the antenna end through the transmission path, in the series switch branch M2 of the reception path, due to the parasitic capacitance between the gate and the source and between the gate and the drain of the series switching transistor, a certain amplitude of radio frequency signal exists in the gate, thus reducing the linearity of the switch. After the parallel small capacitor C2 is additionally arranged, the conductivity between the gate and the source of the switching transistor increases, the signal amplitude of the gate is effectively reduced and the series switch branch M2 of the reception path is kept in a good off state, thus improving the linearity of the radio frequency switch.

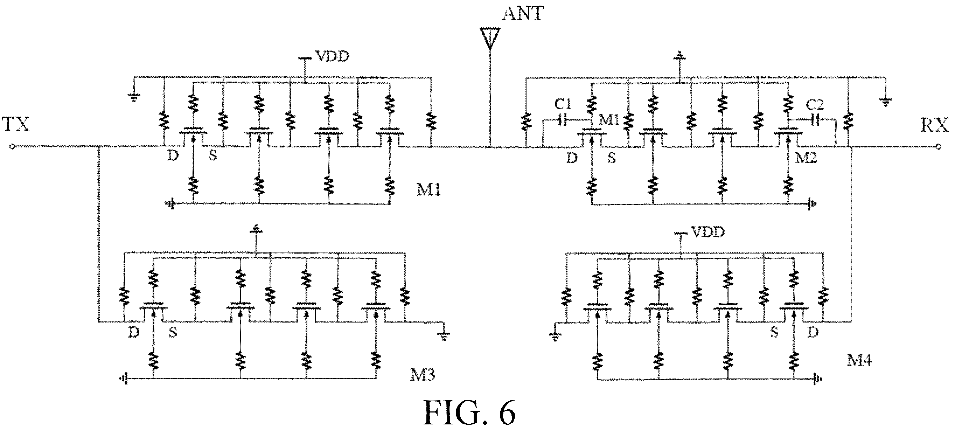

Similarly, as shown in FIG. 6, based on the above technical solution, parallel small capacitors C1 and C2 may also be additionally arranged at two ends of the series switch branch M2 of the reception path, where the small capacitor C1 is connected in parallel between the gate and the drain of the series switch transistor at the antenna end. When the radio frequency switch is in the transmission operating mode and the radio frequency signal is transmitted from the transmission end TX to the antenna end through the transmission path, after the parallel small capacitors C1 and C2 are additionally arranged, the conductivity between the gate and the drain and between the gate and the source of the switching transistor increases, the signal amplitude of the gate is effectively reduced and the series switch branch M2 of the reception path is kept in a good off state, thus further improving the linearity of the radio frequency switch.

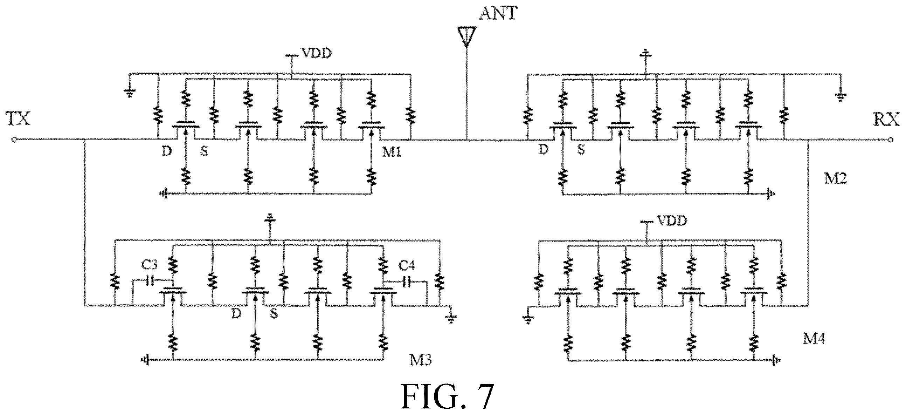

In another embodiment of the present disclosure, in order to improve the linearity of the radio frequency switch, as shown in FIG. 7, a parallel small capacitor C4 is additionally arranged between the gate and the source of the switching transistor at the end of the parallel switch branch M3 of the transmission path connected to the grounding potential end. Alternatively, parallel small capacitors C3 and C4 are additionally arranged at two ends of the parallel switch branch M3 of the transmission path. The small capacitor C3 is connected between the gate and the drain of each switching transistor. When the radio frequency switch is in the transmission operating mode and the radio frequency signal is transmitted from the transmission end TX to the antenna end through the transmission path, after the parallel small capacitor C4 is additionally arranged or the parallel small capacitors C3 and C4 are additionally arranged, the parallel switch branch M3 of the transmission path is kept in a good off state and the leakage of the radio frequency signal to the ground is avoided, thus improving the linearity of the radio frequency switch. An operating principle of this embodiment is the same as the above embodiment, so it will not be repeated.

It should be noted that in other embodiments of the present disclosure, the above-mentioned technical solutions for improving the linearity of the radio frequency switch may also be combined to form new technical solutions for optimizing the linearity of the radio frequency switch.

In order to verify the improvement of the switching time performance index of the radio frequency switch circuit provided in the embodiments of the present disclosure, the inventor conducted simulation tests on the switching time of the radio frequency switch in the technical solution of the present disclosure shown in FIG. 4 and the existing technical solution shown in FIG. 2. Simulation tests were conducted on the radio frequency switch at the antenna end by taking an operating mode of a radio frequency front-end module being switched from a transmission mode (TX mode) to a reception mode (RX mode) as an example. The test results are as follows.

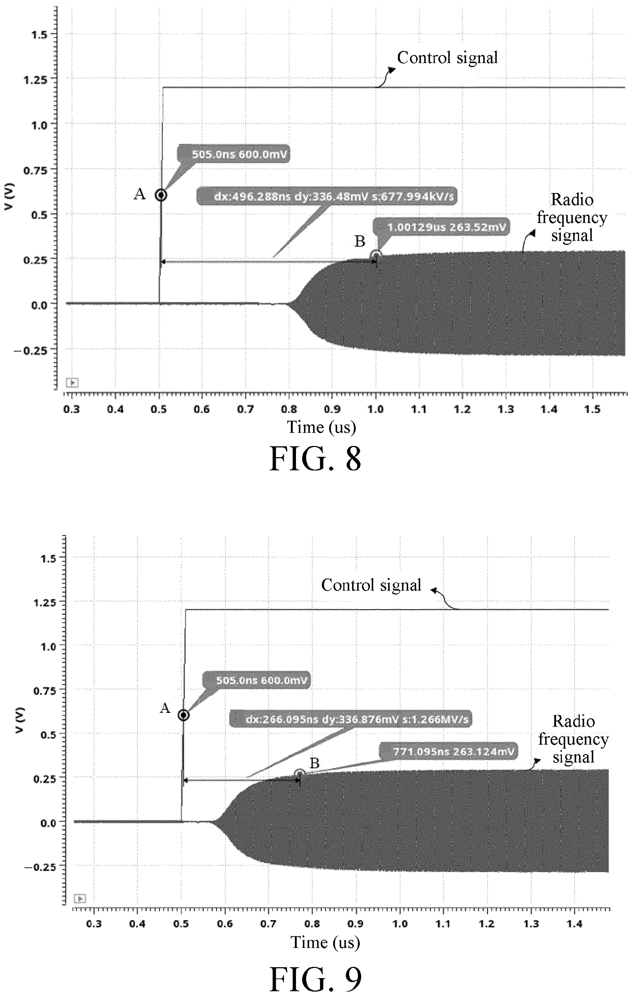

As shown in FIG. 8, it shows a simulation test result of the relative negative voltage radio frequency switch circuit in the prior art, where point A is a time point that a control signal increases to 50%, and point B is a time point that a radio frequency signal amplitude at the reception end reaches 90%. It can be seen from the figure that when the signal path is switched from the transmission path to the reception path, the switching time of the radio frequency switch adopting the existing technical solution is 496 ns.

As shown in FIG. 9, it shows a simulation test result of the radio frequency switch circuit adopting the technical solution in the present disclosure, where point A is a time point that a control signal increases to 50%, and point B is a time point that a radio frequency signal amplitude at the reception end reaches 90%. It can be seen from the figure that when the signal path is switched from the transmission path to the reception path, the switching time of the radio frequency switch adopting the technical solution in the present disclosure is 266 ns. Compared with existing technical solutions, the switching time of the radio frequency switch provided in the present disclosure is reduced by 230 ns, thus effectively improving the transmission rate of the communication system.

An embodiment of the present disclosure further provides an integrated circuit chip. The integrated circuit chip includes the fast-switching radio frequency switch circuit, is used in a radio frequency front-end module of a wireless communication system, and has a function of accurately and synchronously switching the transmission path of the radio frequency signal and gating the corresponding radio frequency path. The specific structure of the fast-switching radio frequency switch circuit in the integrated circuit chip will not be repeated here.

In addition, the radio frequency switch circuit provided in the present disclosure may also be used in an electronic device as an important part of a communication component. The electronic device described here refers to a computer device that can be used in mobile environments and support multiple communication standards such as GSM, EDGE, TD_SCDMA, TDD_LTE and FDD_LTE, including a mobile phone, a laptop, a tablet, a vehicle-mounted computer, or the like. In addition, the technical solution provided in the present disclosure is also applicable to other application scenarios of radio frequency switches, such as communication base stations, intelligent connected vehicles, etc.

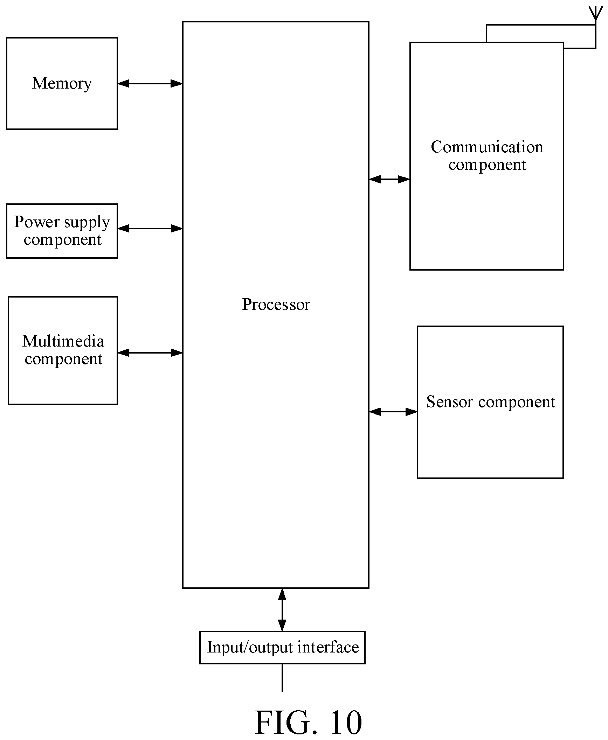

As shown in FIG. 10, the electronic device at least includes a processor and a memory, and may further include a communication component, a sensor component, a power supply component, a multimedia component, and an input/output interface according to the actual need. The memory, the communication component, the sensor component, the power supply component, the multimedia component, and the input/output interface are connected to the processor. The memory may be a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, or the like. The processor may be a central processing unit (CPU), a graphic processing unit (GPU), a field programmable gate array (FPGA), an application-specific integrated circuit (ASIC), a digital signal processing (DSP) chip, or the like. Other components, such as communication component, sensor component, power supply component and multimedia component may be implemented using universal components, which will not be specifically described here.

To sum up, compared with the prior art, in the fast-switching radio frequency switch circuit, the chip and the electronic device thereof provided in the present disclosure, by way of an optimized design of the radio frequency switch circuit, fast switching of operating modes of the radio frequency front-end system is achieved while ensuring performance indexes such as power handling capacity and linearity and not increasing the cost, thus improving the transmission rate of the communication system. Therefore, the fast-switching radio frequency switch circuit provided in the present disclosure has beneficial effects such as ingenious and reasonable design, simple structure, low cost and short switching time, and high linearity.

The fast-switching radio frequency switch circuit, the chip and the electronic device thereof provided in the present disclosure have been described in detail above. Any obvious modifications made thereto by those skilled in the art without departing from the essence of the present disclosure still fall within the scope of protection of the present disclosure.

## Claims

1. A fast-switching radio frequency switch circuit, comprising a series switch branch and a parallel switch branch of at least one transmission path, and a series switch branch and a parallel switch branch of at least one reception path, wherein
in the transmission path, two ends of the series switch branch are respectively connected to a transmission end and an antenna end, and two ends of the parallel switch branch are respectively connected to the transmission end and a grounding potential end;
in the reception path, two ends of the series switch branch are respectively connected to a reception end and the antenna end, and two ends of the parallel switch branch are respectively connected to the reception end and the grounding potential end; and
when the transmission path or the reception path is in an operating state, the series switch branch in the path is closed and the parallel switch branch is opened; and when the transmission path or the reception path is in a non-operating state, the series switch branch in the path is opened and the parallel switch branch is closed.

2. The fast-switching radio frequency switch circuit according to claim 1, wherein
the series switch branch and the parallel switch branch adopt a switching transistor stack structure composed of a plurality of switching transistors with sources and drains sequentially connected in series; and
a body of each switching transistor is connected to the grounding potential end through a body bias resistor, the drain and the source are respectively connected to the grounding potential end through a drain bias resistor and a source bias resistor, and a gate is connected to a bias voltage through a gate bias resistor.

3. The fast-switching radio frequency switch circuit according to claim 1 or 2, wherein when a radio frequency switch is in a transmission operating mode,
in the series switch branch of the transmission path and the parallel switch branch of the reception path in the operating state, and the parallel switch branch of the transmission path in the non-operating state, a gate bias voltage of each switching transistor is a positive voltage; and
in the parallel switch branch of the transmission path and the series switch branch of the reception path in the operating state, and the series switch branch of the transmission path in the non-operating state, the gate bias voltage of each switching transistor is a grounding potential.

4. The fast-switching radio frequency switch circuit according to claim 1 or 2, wherein when a radio frequency switch is in a reception operating mode,
in the series switch branch of the reception path and the parallel switch branch of the transmission path in the operating state, and the parallel switch branch of the reception path in the non-operating state, a gate bias voltage of each switching transistor is a positive voltage; and
in the parallel switch branch of the reception path and the series switch branch of the transmission path in the operating state, and the series switch branch of the reception path in the non-operating state, the gate bias voltage of each switching transistor is a grounding potential.

5. The fast-switching radio frequency switch circuit according to claim 2, wherein
a first parallel capacitor is additionally arranged at an end of the series switch branch of the reception path connected to the reception end, and two ends of the parallel capacitor are respectively connected to the gate and the source of each switching transistor to improve a linearity of a radio frequency switch.

6. The fast-switching radio frequency switch circuit according to claim 2, wherein
a first parallel capacitor and a second parallel capacitor are respectively additionally arranged at two ends of the series switch branch of the reception path, two ends of the first parallel capacitor are respectively connected to the gate and the source of each switching transistor on a reception end, and two ends of the second parallel capacitor are respectively connected to the gate and the drain of each switching transistor on an antenna end to improve a linearity of a radio frequency switch.

7. The fast-switching radio frequency switch circuit according to claim 2, wherein
a third parallel capacitor is additionally arranged at an end of the parallel switch branch of the transmission path connected to the grounding potential end, and two ends of the parallel capacitor are respectively connected to the gate and the source of each switching transistor to improve a linearity of a radio frequency switch.

8. The fast-switching radio frequency switch circuit according to claim 2, wherein
a third parallel capacitor and a fourth parallel capacitor are respectively additionally arranged at two ends of the parallel switch branch of the transmission path, two ends of the third parallel capacitor are respectively connected to the gate and the source of each switching transistor on a grounding potential end, and two ends of the fourth parallel capacitor are respectively connected to the gate and the drain of each switching transistor on a transmission end to improve a linearity of a radio frequency switch.

9. An integrated circuit chip, comprising the fast-switching radio frequency switch circuit according to any one of claims 1 to 8.

10. An electronic device, comprising the fast-switching radio frequency switch circuit according to any one of claims 1 to 8.
